# EUROPÄISCHE PATENTANMELDUNG

(11) **EP 1 028 176 A1**
(43) Veröffentlichungstag der Anmeldung: **16.08.2000**
(21) Anmeldenummer: 99810131.5
(22) Anmeldetag: 12.02.1999
(51) Int. Cl.: C23C 16/44, C30B 25/12, H01L 21/00

(54) **Werkstückhaltevorrichtung sowie Verfahren zu ihrem Betrieb**

(71) Anmelder: Balzers Hochvakuum AG, 9477 Trübbach (CH)
(72) Erfinder: Mahler, Peter, 63512 Hainburg (DE)
(74) Vertreter: Wagner, Wolfgang, Dr. Phil., Dipl.-Phys.

(57) **Zusammenfassung**

Eine Werkstückhaltevorrichtung für eine Vakuumanlage weist in einer Grundplatte (1) unabhängig voneinander verschiebbare kühl- oder heizbare Wärmetransferplatten (2) auf mit jeweils einer von einem O-Ring (4) umgebenen Wärmetransferfläche (3), welche mit einer Leitung (5) verbunden ist und welche mit einem Werkstück (15), das von einer Halterung (16) gegen den O-Ring (4) gepresst wird, einen Spalt (20) einschliesst. Die Halterung (16) ist mit der Grundplatte (1) verriegelbar. Nach Absenken der Halterung (16) in eine Schliesslage und lastfreier Verriegelung mit der Grundplatte (1) werden die Wärmetransferplatten (2) pneumatisch angehoben, bis jeweils ein Anschlag (23, 22) zwischen derselben und der Halterung (16) wirksam wird, der die Weite des Spalts (20) bestimmt. Anschliessend wird der Spalt (20) über die Leitung (5) mit einem Wärmetransfermedium, z. B. Helium gefüllt. Nach Bearbeitung des Werkstücks (15) werden die Wärmetransferplatten (2) abgesenkt und die Halterung (16) wiederum lastfrei entriegelt.

## Beschreibung

Die Vorrichtung betrifft eine Werkstückhaltevorrichtung für eine Vakuumanlage, wie sie zur Fixierung von plattenförmigen Werkstücken wie Wafern oder CDs verwendet werden, die in der Anlage z. B. durch Bedampfen beschichtet werden sollen sowie ein Verfahren zu ihrem Betrieb.

Es ist eine gattungsgemässe Werkstückhaltevorrichtung bekannt (TOPAZ-RFD der Balzers Aktiengesellschaft) mit mehreren Wärmetransferplatten, auf welche zur Beschichtung vorgesehene Werkstücke derart aufgelegt werden, dass sie mit der jeweiligen Wärmetransferplatte einen Spalt einschliessen, in den ein fluides Wärmetransfermedium, insbesondere ein gut wärmeleitendes Gas eingeleitet wird, so dass während des Beschichtungsvorgangs die Werkstücke durch Kühlung der Wärmetransferplatten jeweils über die Gasschicht gekühlt werden. Die Wärmetransferplatten sind in die Grundplatte integriert und die der Fixierung der Werkstücke dienende Halterung wird mit derselben verschraubt.

Diese Lösung, bei welcher die Einstellung der individuellen Lagen der Werkstücke, insbesondere der jeweils zwischen der Wärmetransferplatte und der Unterseite des Werkstücks gebildeten Kühlspalte unter leichter Deformation der Halterung erfolgt, hat verschiedene Nachteile. Die Verschraubung muss manuell vorgenommen werden, was verhältnismässig aufwendig und zeitraubend ist und Raum lässt für Bedienungsfehler. Z. B. können beim Anziehen der Schrauben falsche Drehmomente gewählt werden, was zu falscher Einstellung der Kühlspalte und in der Folge zu ungleichmässiger Kühlung der Werkstücke mit der Folge ungleichmässiger Beschichtung führen kann. Bei der Einstellung der Lagen der Werkstücke kann gegenseitige Beeinflussung nicht ausgeschlossen werden. Ausserdem können beim Verschrauben sehr leicht Partikel entstehen, die sich auf den Werkstücken absetzen und die Produktequalität beeinträchtigen.

Der Erfindung liegt demgegenüber die Aufgabe zugrunde, eine gattungsgemässe Werkstückhaltevorrichtung anzugeben, welche möglichst weitgehend automatisch und mit erhöhter Betriebssicherheit arbeitet sowie ein Verfahren zu ihrem Betrieb, welches ein Verriegeln und Entriegeln der Halterung gewährleistet, bei welchem die Bildung von störenden Partikeln praktisch vollständig vermieden wird. Diese Aufgaben werden durch die Merkmale im Kennzeichen des Anspruchs 1 bzw. 10 gelöst. Weitere Vorteile liegen in der sehr genauen selbsttätigen Einstellung des Spalts, die bei mehreren Werkstücken jeweils ganz unabhängig erfolgt sowie in der Vermeidung der Bildung von störenden Partikeln, was zu einer Verbesserung der Beschichtungsqualität und einer Verminderung des Ausschusses führt. Insbesondere bei Betrieb der erfindungsgemässen Werkstückhaltevorrichtung gemäss dem erfindungsgemässen Verfahren besteht so gut wie keine Gefahr einer Bildung störender Partikel, da Verriegelung und Entriegelung lastfrei und damit praktisch reibungsfrei erfolgen.

Im folgenden wird die Erfindung anhand einer Figur, welche lediglich ein Ausführungsbeispiel darstellt, näher erläutert.

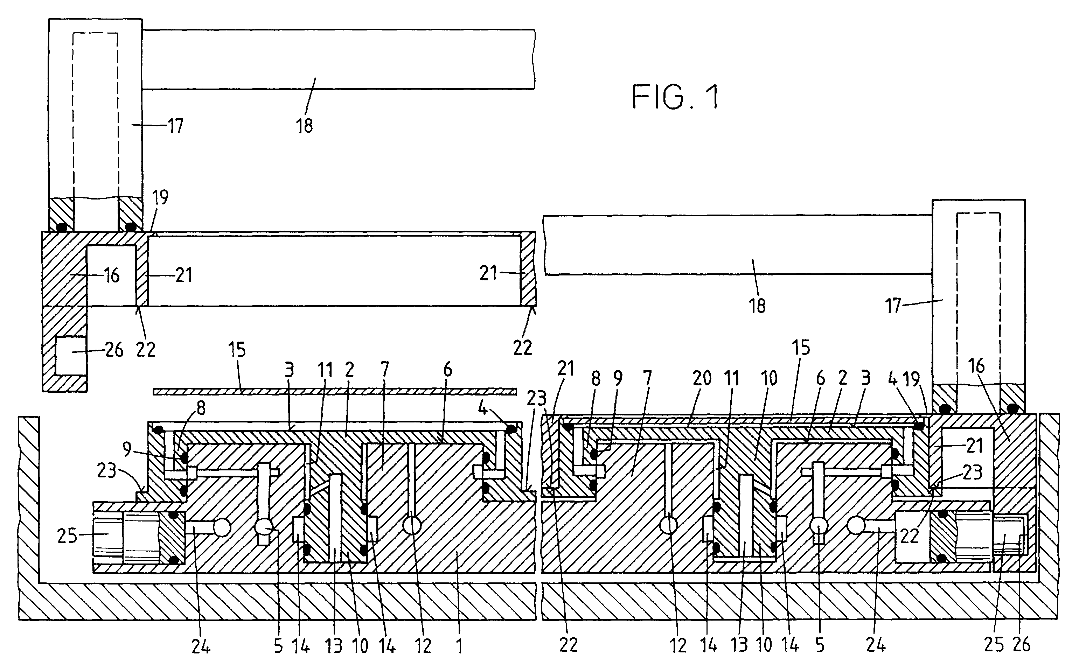

- Fig. 1: zeigt einen Querschnitt durch eine erfindungsgemässe Werkstückhaltevorrichtung, links in der Offenlage, rechts in der Schliesslage.

Eine Grundplatte 1 trägt in zwei nebeneinander angeordneten Reihen eine Anzahl von z. B. runden Wärmetransferplatten 2. Die Oberseite jeder Wärmetransferplatte 2 bildet eine ebene Wärmetransferfläche 3, die von einem umlaufenden O-Ring 4 als Dichtungselement und einem Steg berandet wird. Etwas innerhalb des O-Rings 4 ist die Wärmetransferfläche 3 von einem im wesentlichen geschlossen umlaufenden Spalt unterbrochen, der über mehrere Bohrungen mit einer Leitung 5 verbunden ist.

Die Wärmetransferplatte 2 liegt in der Offenlage mit ihrer Unterseite jeweils auf einer Auflagefläche 6, der Oberseite eines zylindrischen Auflageblocks 7 der Grundplatte 1, auf. Eine umlaufende nach unten weisende Schürze 8 der Wärmetransferplatte 2 trägt eine umlaufende Dichtung 9, die mit der Seitenfläche des Auflageblocks 7 zusammenwirkt. Ein mittig an der Unterseite angeordneter zylindrischer Fortsatz 10 der Wärmetransferplatte 2 ist verschiebbar in einer Bohrung 11 der Grundplatte 1 gelagert, welche im Zentrum des Auflageblocks 7 angeordnet ist. Durch den Auflageblock 7 führt ausserdem eine Druckmittelleitung 12 bis zur Auflagefläche 6. Der obere Teil der Bohrung 11 umgibt den Fortsatz 10 mit Abstand. Der freie Zwischenraum dient zusammen mit einem anschliessenden, axial bis zur Stirnfläche desselben durch den Fortsatz 10 geführten Kanal 13 dem Druckausgleich. Durch die Grundplatte 1 führen ausserdem Kanäle 14, die bis direkt an den Fortsatz 10 herangeführt sind.

Das zu beschichtenden Werkstück 15 - es kann sich z. B. um eine runde Kunststoffplatte handeln, einen CD-Rohling, der mit einer Aluminiumschicht versehen wird - liegt bei der Bearbeitung auf dem O-Ring 4 auf. Zu seiner Fixierung in dieser Lage dient eine Halterung 16, welche mittels eines Vakuumhebers 17 mit einem Griff 18 zwischen einer links dargestellten Offenlage, in der sie von der Grundplatte 1 abgehoben ist und einer rechts dargestellten Schliesslage, in welcher sie auf die Grundplatte 1 abgesenkt ist, senkrecht zu den Wärmetransferflächen 3 hin und her bewegt werden kann. Die Halterung 16 weist jeder Wärmetransferplatte 2 gegenüber einen umlaufenden Vorsprung 19 auf, der einen gegen die Wärmetransferfläche 3 weisenden Fixieranschlag bildet, welcher in der Schliesslage gegen den Randbereich des Werkstücks 15 drückt. Dasselbe wird dabei gegen den O-Ring 4 gepresst, der dadurch elastisch komprimiert wird und einen zwischen der Unterseite des Werkstücks 15 und der Wärmetransferfläche 3 gebildeten Spalt 20 abdichtet, dessen Weite nicht grösser als 1 mm, insbesondere nicht grösser als 0,3 mm ist, vorzugsweise aber ca. 0,1 mm oder weniger beträgt.

Die Halterung 16 weist Stege 21 auf, einen umlaufenden Randsteg und einen durchgehenden mittleren Steg, welche gegen die Wärmetransferplatten 2 weisende, zu den Wärmetransferflächen 3 parallele Anschlagflächen 22 bilden. In der Schliesslage stossen sie gegen Gegenanschlagflächen 23 an den Wärmetransferplatten 2, mit denen zusammen sie Anschläge bilden, welche die Lagen der Wärmetransferplatten 2 relativ zur Halterung 16 bestimmen.

Zur Verriegelung der Halterung 16 in der Schliesslage weist die Grundplatte 1 eine Verriegelungsvorrichtung auf mit mehreren vorzugsweise pneumatisch, über Druckleitungen 24, vorschieb- und zurückziehbaren Riegeln 25, welche in entsprechende Ausnehmungen 26 in der Halterung 16 eingreifen.

Vor Evakuierung der Vakuumkammer werden die Werkstücke 15 manuell auf die O-Ringe 4 aufgelegt. Dann wird jeweils der Spalt 20 über die Leitung 5 evakuiert und leckgeprüft und die Halterung 16 aufgelegt und die Verriegelung zwischen derselben und der Grundplatte 1 durch Vorschieben der Riegel 25 aktiviert. Dies erfolgt lastfrei und damit weitgehend reibungsfrei, da die Grundplatte 1 und die Halterung 16 noch nicht gegeneinander verspannt sind. Eine Verspannung dieser Teile erfolgt erst anschliessend, indem die Wärmetransferplatten 2 ebenfalls pneumatisch, d. h. jeweils durch Einleiten von Druckgas in den Spalt zwischen der Auflagefläche 6 und der Unterseite der Wärmetransferplatte 2 über die Druckmittelleitung 12 mit einer gegen die Halterung 16 gerichteten elastischen Kraft beaufschlagt und angehoben werden, bis die Gegenanschlagflächen 23 gegen die Anschlagflächen 22 stossen und somit der Anschlag zwischen der Wärmetransferplatte 2 und der Halterung 16 wirksam wird und deren relative Lage bestimmt.

Die Lage des Werkstücks 15 relativ zur Wärmetransferfläche 3 ist dann durch den zwischen der Oberfläche des Werkstücks 15 und der Unterseite des Vorsprungs 19 gebildeten Fixieranschlag sowie die konstante Dicke des Werkstücks 15 ebenfalls genau definiert und die Weite des Spaltes 20 festgelegt. Durch die unabhängige Beweglichkeit der Wärmetransferplatten 2 und den Charakter der auf sie einwirkenden Kräfte stellt sich der Spalt 20 jeweils ohne gegenseitige Beeinflussung der Wärmetransferplatten ein, obwohl sie alle gemeinsam pneumatisch betätigt werden.

Nun wird die Vakuumkammer evakuiert und jeweils der Spalt 20 über die Leitung 5 mit einem fluiden Wärmetransfermedium, insbesondere einem gut wärmeleitenden Gas wie Helium gefüllt, das einen ausgezeichneten und gleichmässigen thermischen Kontakt zwischen der Wärmetransferplatte 2, die ihrerseits über die Kanäle 14 durch Einleitung eines Kühlmediums, vorzugsweise Wasser gekühlt wird, und dem Werkstück 15 herstellt. Nun kann die Beschichtung durch Bedampfen, Kathodenstrahlzerstäubung oder einen ähnlichen Prozess durchgeführt werden, während gleichzeitig die Werkstücke 15 jeweils über die Wärmetransferplatte 2 und den gasgefüllten Spalt 20 gekühlt wird.

Nach Abschluss des Beschichtungsvorgangs wird die Vakuumkammer geflutet. Dann wird jeweils über die Druckmittelleitung 12 die Luft aus dem Spalt zwischen der Auflagefläche 6 und der Unterseite der Wärmetransferplatte 2 abgezogen und dadurch die letztere abgesenkt. Damit wird die zwischen der Halterung 16 und der Grundplatte 1 wirksame Verriegelung entlastet und anschliessend die Riegel 25 lastfrei aus den Ausnehmungen 26 zurückgezogen. Durch das last- und damit praktisch reibungsfreie Vorschieben und Zurückziehen der Riegel 25 wird die Bildung von störenden Partikeln so gut wie vollständig vermieden. Schliesslich wird das Gas aus dem Spalt 20 abgezogen und derselbe mit Luft gespült. Dann wird die Halterung 16 angehoben und die Werkstücke 15 werden entnommen.

Es sind natürlich verschiedene Abwandlungen des beschriebenen Betriebs der Vorrichtung möglich. So kann das Wärmetransfermedium auch eine Flüssigkeit sein. Das gilt auch für das Druckmittel, d. h. die Wärmetransferplatte kann statt pneumatisch auch hydraulisch angehoben werden sowie für die Verriegelungsvorrichtung. Und schliesslich kann die Vorrichtung statt zur Kühlung auch zur Heizung eines Werkstücks Verwendung finden.

### Bezugszeichenliste

1 Grundplatte
2 Wärmetransferplatte
3 Wärmetransferfläche
4 O-Ring
5 Leitung
6 Auflagefläche
7 Auflageblock
8 Schürze
9 Dichtung
10 Fortsatz
11 Bohrung
12 Druckmittelleitung
13 Kanal
14 Kanäle
15 Werkstück
16 Halterung
17 Vakuumheber
18 Griff
19 Vorsprung
20 Spalt
21 Stege
22 Anschlagflächen
23 Gegenanschlagflächen
24 Druckleitungen
25 Riegel
26 Ausnehmungen

## Patentansprüche

1. Werkstückhaltevorrichtung für eine Vakuumanlage,
- mit einer Grundplatte (1), welche mindestens eine Wärmetransferplatte (2) trägt mit einer Wärmetransferfläche (3), welche mit einer Leitung (5) verbunden ist und welche von einem Dichtungselement umgeben ist zur Auflage eines Werkstücks (15) auf die Wärmetransferplatte (2) mit einem dasselbe von der Wärmetransferfläche (3) trennenden Spalt (20) zur Aufnahme eines Wärmetransfermediums,
- mit einer zwischen einer Schliesslage und einer Offenlage senkrecht zur Wärmetransferfläche (3) verschiebbaren Halterung (16), welche mindestens einen gegen die Wärmetransferfläche (3) weisenden Fixieranschlag zum Anpressen des Werkstücks (15) an das Dichtungselement in der Schliesslage aufweist sowie
- mit einer in der Schliesslage zwischen der Grundplatte (1) und der Halterung (16) wirksamen Verriegelungsvorrichtung,
**dadurch gekennzeichnet, dass** die Wärmetransferplatte (2) gegenüber der Grundplatte (1) senkrecht zur Wärmetransferfläche (3) verschiebbar ist und ein zwischen der Wärmetransferplatte (2) und der Halterung (16) wirksamer Anschlag vorgesehen ist, welcher in der Schliesslage die gegenseitige Lage derselben bestimmt.

2. Werkstückhaltevorrichtung nach Anspruch 1, **dadurch gekennzeichnet, dass** die Wärmetransferplatte (2) in der Schliesslage mit einer gegen die Halterung (16) gerichteten Kraft beaufschlagbar ist, deren Wirkung zur Einstellung der Weite des das Werkstück (15) von der Wärmetransferfläche (3) trennenden Spalts (20) durch den Anschlag begrenzt ist.

3. Werkstückhaltevorrichtung nach Anspruch 1 oder 2, **dadurch gekennzeichnet, dass** die Weite des das Werkstück (15) von der Wärmetransferfläche (3) trennenden Spaltes (20) nicht grösser als 1 mm, insbesondere nicht grösser als 0,3 mm ist.

4. Werkstückhaltevorrichtung nach Anspruch 2 oder 3, **dadurch gekennzeichnet, dass** zur Aufbringung der Kraft hydraulische oder vorzugsweise pneumatische Mittel vorgesehen sind.

5. Werkstückhaltevorrichtung nach Anspruch 4, **dadurch gekennzeichnet, dass** die Unterseite der Wärmetransferplatte (2) auf einer Auflagefläche (6) der Grundplatte (1) aufliegt, in welche eine Druckmittelleitung (12) mündet.

6. Werkstückhaltevorrichtung nach Anspruch 5, **dadurch gekennzeichnet, dass** die Auflagefläche (6) die Oberseite eines Auflageblocks (7) bildet und von einer nach unten weisenden Schürze (8) der Wärmetransferplatte (2) überkragt wird, welche gegen die Seitenfläche des Auflageblocks (7) durch eine umlaufende Dichtung (9) abgedichtet ist.

7. Werkstückhaltevorrichtung nach einem der Ansprüche 1 bis 6, **dadurch gekennzeichnet, dass** die Wärmetransferplatte (2) mindestens einen an ihrer Unterseite angebrachten Fortsatz (10) aufweist, welcher in einer Bohrung (11) der Grundplatte (1) verschiebbar gelagert ist.

8. Werkstückhaltevorrichtung nach einem der Ansprüche 1 bis 7, **dadurch gekennzeichnet, dass** die zwischen der Grundplatte (1) und der Halterung (16) wirksame Verriegelungsvorrichtung hydraulisch oder vorzugsweise pneumatisch betätigbar ist.

9. Werkstückhaltevorrichtung nach einem der Ansprüche 1 bis 8, **dadurch gekennzeichnet, dass** die Verriegelungsvorrichtung mindestens annähernd parallel zur Wärmetransferfläche (3) verschiebbar in der Grundplatte (1) gelagerte vorschieb- und zurückziehbare Riegel (25) zum Eingriff in entsprechende Ausnehmungen (26) in der Halterung (16) umfasst.

10. Werkstückhaltevorrichtung nach einem der Ansprüche 1 bis 9, **dadurch gekennzeichnet, dass** die Grundplatte (1) und die Halterung (16) jeweils einstückig ausgebildet sind und die Grundplatte (1) mehrere unabhängig voneinander verschiebbare Wärmetransferplatten (2) aufweist.

11. Verfahren zum Betrieb einer Werkstückhaltevorrichtung nach einem der Ansprüche 2 bis 10, bei welchem die Halterung (16) vor Beginn der Bearbeitung eines Werkstücks (15) in Schliesslage gebracht und mit der Grundplatte (1) verriegelt und nach der Bearbeitung des Werkstücks (15) entriegelt und in Offenlage gebracht wird, **dadurch gekennzeichnet, dass** die Wärmetransferplatte (2) während der Bearbeitung des Werkstücks (15) mit einer gegen die Halterung (16) gerichteten Kraft beaufschlagt wird, nicht jedoch während der Verriegelung und der Entriegelung derselben.

12. Verfahren nach Anspruch 11, **dadurch gekennzeichnet, dass** zu Beginn der Bearbeitung des Werkstücks ein gut wärmeleitendes Gas, insbesondere Helium als Wärmetransfermedium in den Spalt (20) zwischen der Wärmetransferfläche (3) und der Unterseite des Werkstücks (15) eingeleitet wird.
